Europäisches Patentamt

European Patent Office

Office européen des brevets

(19)

(11) Veröffentlichungsnummer: **0 000 169**
**B1**

(12) **EUROPÄISCHE PATENTSCHRIFT**

(45) Veröffentlichungstag der Patentschrift: **07.10.81**

(21) Anmeldenummer: **78100194.6**

(22) Anmeldetag: **19.06.78**

(51) Int. Cl.³: **H 01 L  27/08,**
**H 03 K   19/003**

(54) **Halbleitersperrschichtkapazität in integrierter Bauweise und Bootstrap-Schaltung mit einer derartigen Halbleitersperrschichtkapazität.**

(30) Priorität: **29.06.77 US  811028**

(43) Veröffentlichungstag der Anmeldung:
**10.01.79 Patentblatt 79/1**

(45) Bekanntmachung des Hinweises auf die Patenterteilung:
**07.10.81 Patentblatt 81/40**

(84) Benannte Vertragsstaaten:
**DE FR GB**

(56) Entgegenhaltungen:
**DE - A - 1 764 148**
**US - A - 3 544 862**

(73) Patentinhaber: **International Business Machines Corporation**
**Armonk, N.Y. 10504 (US)**

(72) Erfinder: **Tomczak, James Joseph**
**64 Sandy Lane**
**Burlington Vermont 05401 (US)**
Erfinder: **Wilson, Richard Norman**
**10 Richard Street**
**Essex Junction Vermont 05452 (US)**

(74) Vertreter: **Teufel, Fritz, Dipl.-Phys.**
**Schönaicher Strasse 220**
**D-7030 Böblingen (DE)**

Courier Press, Leamington Spa, England.

## Halbleitersperrschichtkapazität in integrierter Bauweise und Bootstrap-Schaltung mit einer derartigen Halbleitersperrschichtkapazität

Die Erfindung betrifft eine Halbleitersperrschichtkapazität in integrierten Bauweise nach dem Oberbegriff von Anspruch 1 und deren Verwendung in einer Bootstrap-Schaltung.

Beim Entwurf digitaler Systeme ist es oft notwendig, zwei verschiedene Technologien integrierter Schaltkreise, beispielsweise bipolare und Feldeffektanordnungen zu verwenden, wenn der vorgegebene Leistungsbereich für die Schaltung erreicht werden soll. So werden häufig bipolare Schaltkreise für Anwendungen in logischen Kreisen und bei Taktgebern verwendet, Feldeffektschaltungen dagegen für Speicheranwendungen. Da bipolare Schaltungen im allgemeinen bei Spannungen arbeiten, die beträchtlich unter den Werten liegen, die für den Betrieb von Feldeffektschaltkreisen erforderlich sind, werden Pufferschaltkreise notwendig, um die bipolaren Signalpegel auf den Pegel von Feldeffektschaltungen anzuheben. Üblicherweise dienen zur Realisierung dieser Pufferfunktion bipolare Schaltkreise.

Da Feldeffektschaltkreise besonders dazu neigen, Spannungsabfälle in der Größe einer Schwellwertspannung (typischerweise 0,5 bis 1,5 V) pro logischer Stufe zu erzeugen, ist es besonders wichtig, daß die Eingangssignale für Feldeffektkreise so nahe wie möglich dem Versorgungspotential der Drain-Elektrode diese Kreise liegen (typischerweise 8 bis 15 V). Fast ausschließlich werden Emitterfolger verwendet; zur Eliminierung oder Herabsetzung des Spannungsabfalls-Basis/Emitter, der unvermeidlich in solchen Schaltkreisen auftritt, wird in der einen oder anderen Form eine kapazitive Ladungszurückhaltung oder ein Bootstrap-Element eingesetzt. Beispielsweise wird in der US—Patentschrift 3 656 004 die eingebaute Kapazität zwischen Basis und Emitter selbst verwendet, um zusätzliche gespeicherte Ladung zu liefern, mit der der Ausgangsemitterfolger noch eine ausreichend lange Zeit im leitenden Zustand ausfrechterhalten werden kann, nachdem der Treiberschaltkreis für die Basis schon nichtleitend geworden ist, so daß die Ausgangsspannung den Wert des Versorgungspotentials erreicht. Der Artikel "Bipolare Bootstrap-Schaltung" im IBM Technical Disclosure Bulletin, Febr. 76, Seiten 2818 bis 2819, beschreibt eine ähnliche Technik zur Ladungsspeicherung, in der die Basis-Kollektor-Kapazität eines bipolaren Transistors dazu verwendet wird, zusätzlichen Strom zu liefern, mit dem der Treiberkreis nach dem Schalten seiner Quelle noch im leitfähigen Zustand gehalten wird. In beiden Beispielen ist der Betrag der zurückhaltbaren Ladung begrenzt durch die großen Störkapazitäten zwischen den Schaltungselementen und dem Substrat der integrierten Schaltung, sowie durch die Zeit, die zum Laden der internen Kapazitäten nach Einsetzen des Ausgangssignals erforderlich ist.

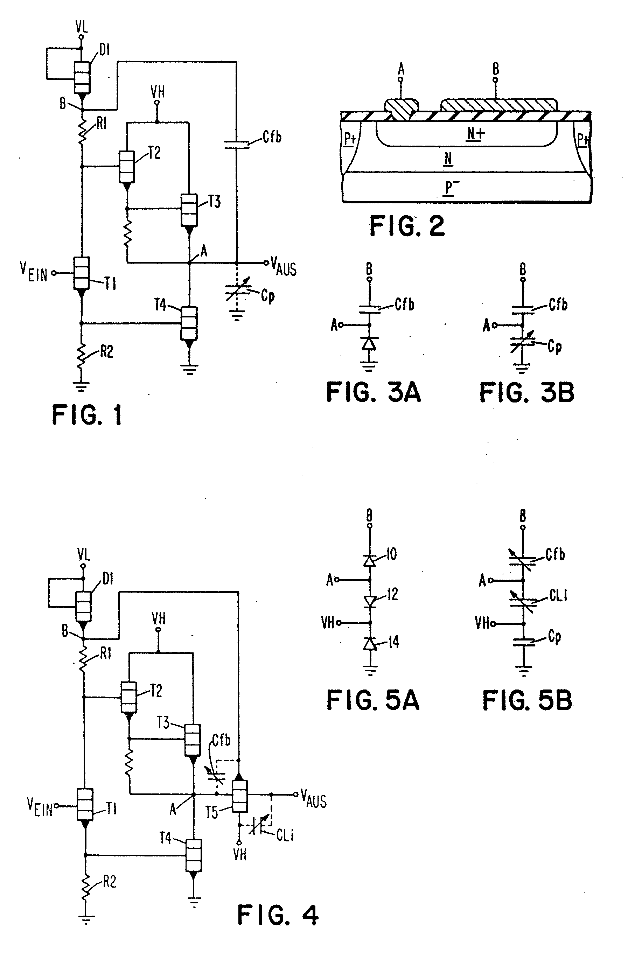

In dem Artikel "Takttreiber für dynamische MOS—FET—Schieberegistermatritzen" im IBM Technical Disclosure Bulletin, Febr. 1974, Seiten 2767 bis 2768 und in der US—Patentschrift 4 002 931, wird eine Bootstrap-Kapazität verwendet, die zwischen dem Ausgang des Emitterfolgers und seinem Eingang liegt; dadurch ergibt sich ein hochgesetzter Spannungspegel, mit dem die Ausgangsschaltung leitend gehalten wird, nachdem das Eingangssignal für die Treiberschaltung im Normalfall schon abgeklungen ist. Fig. 1 zeigt eine vereinfachte Treiberschaltung des Bootstrap-Typs, in der Eingangssignal $V_{ein}$ an T1 angelegt wird und ein invertiertes Ausgangssignal $V_{aus}$ am spannungsknoten A erscheint. Wenn $V_{ein}$ ein logisches Signal mit hohem Pegel ist, leitet T1 und damit auch T4, der den Knoten A an Erde legt. Wenn T1 leitet, liegt die Basis von T2 in der Nähe des Erdpotentials und $T_2$ ist ausgeschaltet. Der Spannungsabfall an R1 ermöglicht es dem Rückkoppelkondensator Cfb, sich auf ungefähr VL minus $V_{be}$ der diode D1 aufzuladen. Wenn das Eingangssignal von seinem hohen auf den niedrigen logischen Pegel übergeht, werden T1 und T4 augesschaltet. Die Basis von T2 steigt dann potentialmäßig und schaltet damit T2 ein, wodurch auch T3 leitend wird und das Ausgangssignal $V_{aus}$ ansteigen läßt. Die Geschwindigkeit, mit der das Potential im Knoten A ansteigt, wird durch die Größe der beaufschlagten kapazitiven Last (die nicht eingezeichnet ist) bestimmt, sowie durch die Größe von Cfb und die Größe verschiedener Parasitärkapazitäten, die zusammengefaßt als variable Kapazität $C_p$ dargestellt sind. Je größer $C_p$ wird, desto größer muß Cfb sein, damit genügend Rückkopplung zum Knoten B zur Verfügung steht, um der Basis von T2 Strom zuzuführen und solange leitend zu halten, bis Knoten A das Versorgungspotential VH der Drain-Elektrode erreicht. In vielen Fällen ist Cfb zu groß, als daß ein Kondensator entsprechender Kapazität auf demselben Substrat wie der übrige Schaltkreis eingebaut werden könnte; er wird deshalb als diskrete externe Komponente ausgeführt. Die oben erwähnte US—Patentschrift 4 002 931 beschreibt eine integrierte Kapazität mit dünner Oxydschicht, entsprechend der Darstellung in Fig. 2. Der Ausgang am Knoten A ist leitend mit einem N+—dotierten Halbleiterbereich verbunden, wobei die P+-Isolationswannen in der auf einem P—Substrat gewachsenen Epitaxialschicht vom Typ N ausgebildet sind. Die Kapizität Cfb zwischen den Kontakten A und B ist zwar konstant, die Kapazität zwischen dem Kontakt A und dem Substrat enthält aber eine in Sperrichtung vorgespannte P-N-Grenzschicht Fig. 3A ist eine schematische Darstellung des in Fig. 2 gezeigten Kondensators, Fig. 3B ist eine Darstellung der kapazitiven Effekte des Kondensators, wenn das Potential am Knoten A ansteigt. Die Charakteristiken der in Sperrichtung gepolten Diode entsprechen einem variablen Kondensator CP, dessen Kapazität ansteigt, wenn das Potential am Knoten A zunimmt. Da das Verhältnis von Cfb zu Cp klein sein kann, wird die Wirksamkeit der Rückkopplung herabgesetzt. Obwohl andere Kondensatorstrukturen, beispiesweise Sperrschichtkapazitäten wie in der US—Patentschrift 3 474 309 herangezogen werden können, so weisen diese doch ebenfalls große parasitäre Kapazitäten auf, die mit den Kondensatoranschlüssen gekoppelt sind und die Effektivität dieses Schaltkreises herabsetzen.

Als weiterer Stand der Technik, der hier von Interesse ist, kann genant werden: US—Patentschrift 3 641 368, in der ein NPN-Transistor mit kurzgeschlossenem Kollektor-Emitter als Kapazität verwendet wird und die US—Patentschrift 3 678 348, in den ein bipolarer Multiemittertransistor gezeigt ist, bei dem mehrere Kontakte gemeinsam mit einer einzigen Emitterelektrode und einer getrennten Mehrfachkontaktbasiselektrode verbunden sind.

Aus der deutschen Offenlegungsschrift DE—A 17 64 148 ist eine Halbleitersperrschichtkapazität in integrierter Bauweise bekannt, bei dem erste und zweite Grenzschichtdioden angeordnet sind, wobei die zweite Diode bezüglich der anderen umgekehrt gepolt ist und bei der alle Dioden in Sperrichtung betrieben werden (vgl. Oberbegriff von Anspruch 1). Außerdem ist es aus dieser Schrift bekannt, daß die pn-Grenzschichtdioden als eine, einem Transistor entsprechende Struktur auf einem einzigen Halbleiterplättchen ausgebildet sind, wobei die erste pn-Grenzschichtdiode einem dem Emitter entsprechenden Bereich zusammen mit einem der Basis entsprechenden Bereich umfaßt und die zweite pn-Grenzschichtdiode den der Basis entsprechenden Bereich zusammen mit einem dem Kollektor entsprechenden Bereich, wobei ferner eine Mehrzahl von der dem Emitter entsprechenden Bereiche in einem gemeinsam der Basis entsprechenden Bereich angeordnet und mit einer gemeinsamen Ausgangsklemme verbunden sind. Ein derartiger Aufbau einer Halbleitersperrschichtkapazität ermöglicht es jedoch nicht, parasitäre Kapazitäten, z.B. in Bootstrap-Schaltungen, auszuschalten.

Die Aufgabe der vorliegenden Erfindung besteht dementsprechend darin, eine verbesserte integrierte bipolare Halbleitersperrschichtkapazität anzugeben, mit der insbesondere die störenden Effekte parasitärer Kapazitäten in Bootstrap-Schaltungen herabgesetzt werden.

Diese Aufgabe wird durch die in den Ansprüchen 1 und 5 gekennzeichnete Erfindung gelöst; Besondere Ausführungsorten der Erfindung sind in den Unteransprüchen gekennzeichnet.

Die Erfindung verwendet eine Halbleitersperrschichtkapazität mit mehreren Halbleitergrenzschichten, bei der drei in Reihe geschaltete p-n-Grenzschichten zwischen einem Bezugspotential und einer Ausgangsklemme angeordnet sind, und bei der die mittlere p-n-Grenzschicht bezüglich der beiden anderen Grenzschichten umgekehrt gepolt ist. Indem alle diese Grenzschichten in Sperrichtung gepolt bleiben, erzeugt ein Eingangssignal, das zwischen den beiden der Ausgangsklemme am nächsten liegenden Grenzschichten zugeführt wird, eine spannungsabhängige Kapazität zwischen dem Eingangssignal und der Ausgangsklemme, während die mittlere PN-Grenzschicht eine kapazitive Trennung zwischen Eingangssignal und Bezugspotential liefert. Die Verwendung der spannungsabhängigen Kapazität als Bootstrap-Kapazität in einem Bipolar-Treiberschaltkreis liefert einen Schaltkreis, der einen weiten Arbeitsbereich aufweist, und zwar hauptsächlich infolge der eingebauten Lastkapazität, die für das Eingangssignal durch die Kapazität der mittleren p-n-Grenzschicht geliefert wird.

Ein Weg zur Ausführung der Erfindung wird nun anhand von Zeichnungen näher erläutert. Es zeigen:

Fig. 1 einen schematischen Schaltkreis einer bipolaren Bootstrap-Treiberschaltung nach dem Stand der Technik,

Fig. 2 einen schematischen Querschnitt einer Kondensatorstruktur (Kapazität) nach dem Stand der Technik,

Fign. 3A und 3B schematische Schaltkreise mit zwei verschiedenen elektrischen Darstellungen der in Fig. 2 dargestellten Kapazität,

Fig. 4 einen schematischen Schaltkreis einer bipolaren Bootstrap-Treiberschaltung in der die erfindungsgemäße Halbleitersperrschicht-kapazität als bipolarer Transistor dargestellt ist,

Fign. 5A und 5B schematische Schaltbilder alternativer elektrischer Schaltkreise Halbleitersperrschichtkapazität von Fig. 4,

Fig. 6 ein schematisches Schaltbild einer anderen Ausführung des bipolaren Bootstrap-Treiberschaltkreises,

Fig. 7A eine Aufsicht auf eine Ausführungsform der Halbleitersperrschichtkapazität mit mehrfachen emitterähnlichen und basisähnlichen Kontaktbereichen des in Fig. 6 dargestellten kapazitiven Elements T5,

Fig. 7B einen Querschnitt der Halbleitersperrschichtkapazität von Fig. 7A links der Linie B—B mit dem vertikalen Profil der Struktur.

Fig. 4 zeigt eine Ausführung der Erfindung in Form eines bipolaren Bootstrap-Treiberschaltkreises mit einem Emitterfolger vom Darlington-Typ. Der Schaltkreis soll beim Anlegen eines Eingangssignals $V_{ein}$, das von einer bipolaren Logikschaltung geliefert wird, ein Ausgangssignal $V_{aus}$ liefern, dessen Spannungs-

pegel zwischen dem Erdpotential und der Versorgungsspannung $V_H$ für die Drain-Elektroden eines getriebenen Feldeffekttransistor-(FET)-Schaltkreises liegen. Der Schaltkreis umfaßt einen Eingangstransistor $T_1$, dessen Basis mit $V_{ein}$ gekoppelt ist und dessen Kollektor mit dem Eingang eines Darlington-Verstärkerpaars T2 und T3 verbunden ist. Der Emitter von T1 ist über den Widerstand R2 an Erde gelegt und direkt mit der Basis des Transistors T4 verbunden, der zum schnellen Herabsetzen des Ausgangssignals verwendet wird. Der Kollektor von T1 ist weiterhin über einen als Diode geschalteten Transistor ist weiterhin Widerstand R1 mit einer niederpegeligen Spannung VL verbunden. Der Verstärker- oder Treiberteil des Schaltkreises enthält die Transistoren T2 und T3, deren Kollektoren mit dem Versorgungspotential VH der PET-Drain-Elektroden verbunden sind. Der Ausgang des Verstärkers ist beim Spannungsknoten A mit dem Kollektor des Transistors T4 verbunden. Zwischen dem Knoten A und der Ausgangsklemme $V_{aus}$ liegt ein Element T5, das Ähnlichkeit mit einem bipolaren Transistor aufweist und dessen Basis sowohl mit dem Knoten A als auch mit $V_{aus}$ verbunden ist. Der Kollektor von T5 ist mit VH verbunden, der Emitter mit dem Spannungsknoten B zwischen R1 und D1. Die Vorspannung von T5 ist so, daß keine Transistorwirkung eintritt und das Element nur als Paar von Grenzschichtkapazitäten wirkt, die das Ausgangssignal $V_{aus}$ über die Rückkoppelkapazität Cfb an Knoten B geben und das Ausgangssignal $V_{aus}$ mit VH über die interne Lastkapazität CLi koppeln.

Im Betrieb arbeitet der Schaltkreis nach Fig. 4 folgendermaßen: Wenn $V_{ein}$ den hohen Pegel einnimmt, wird T1 leitend und es fließt ein Strom von VL über D1, R1, T1 und R2 zur Masse. Strom durch R2 läßt die Basis von T4 über den Wert Vbe ansteigen und schaltet somit den Transistor T4 ein, der dann den Knoten A und $V_{aus}$ auf Massenpotential legt. Die Spannungsteilung durch D1, R1 und R2 hält das Basispotential von T2 so gering, daß T2 und T3 nichtleitend bleiben. Der Knoten B behält jedoch eine Spannung bei, die ungefähr gleich VL minus Vbe von D1 ist und somit bewirkt, daß die Emitter/Basis-Grenzschicht von T5 in Sperrichtung gepolt wird und Cfb auflädt. Der mit VH verbundene Kollektor von T5 liefert eine Sperrspannung für die Kollektor-Basis-Grenzschicht, die CLi lädt.

Wenn $V_{ein}$ auf den niederen Pegel übergeht, schaltet T1 aus und damit auch T4, so daß das Ausgangssignal nicht mehr auf Massenpotential festgehalten wird. Beim Ausschalten von T1 steigt das Potential an der Basis von T2, sowohl T2 als auch T3 schalten ein und das Potential am Knoten A und die Spannung $V_{aus}$ nehmen in Richtung VH zu. Wird für einen Augenblick angenommen, daß T5 nicht vorhanden ist, so wäre die Transistorwirkung von T2 auf den Bereich begrenzt, in dem der Knoten A mehr als ungefähr zwei bis drei Vbe-Spannungsabfälle unter VL liegt, da R1 nicht in der Lage wäre, Strom an die Basis von T2 zu liefern, wenn die Spannungsdifferenz an R1 null wird. Im vorliegenden Schaltkreis ist die Spannung aufgrund der Vorladung auf Cfb kapazitiv an Knoten B gekoppelt, der dadurch auf ein Potential $V_{aus}$ plus der Vorladungsspannung (VL minus Vbe) ansteigt und somit bewirkt, daß Knoten B beträchtlich über das Vorladungspotential (VL minus Vbe) ansteigt. Der Spannungsanstieg ermöglicht es T2 und T3 leitend zu bleiben, bis $V_{aus}$ im wesentlichen den Wert VH erreicht; damit ist das gewünschte Ziel erreicht. Während $V_{aus}$ ansteigt, wirkt die interne Lastkapazität CLi, die durch Sperren der Kollektor-Basis-Grenzschicht von T5 gebildet wird, als Begrenzer für die Anstiegszeit des Ausgangssignals. Wie noch erläutert wird, kann das Verhältnis von Cfb und CLi während des Herstellprozesses so eingestellt werden, daß sich sowohl die gewünschte Rückkopplung als auch die gewünschte interne Lastkapazität ergibt. Hier ist zu beachten, daß bei diesem Schaltkreis, anders als im Stand der Technik (Fig. 1), keine relativ große parasitäre Kapazität Cp zwischen Ausgang und Masse vorhanden ist.

Fig. 5A ist eine Darstellung der Diodeneigenschaften des kapazitiven Elements T5; danach besteht es aus in Reihe geschalteten pn-Grenzschicht-Dioden, namlich der Emitter-Basis-Diode, d.h. der ersten pn-Grenzschichtdiode 10, der Basis-Kollektor-Diode d.h. der zweiten pn-Grenzschichtdiode 12 und der Kollektor-Isolationsdiode, d.h. der dritten pn-Grenzschichtdiode, 14. Alle diese drei pn-Grenzschichten sind dauernd in Sperrichtung gepolt. Die erste pn-Grenzschichtdiode 10 wird anfangs über die Ausgangsklemme B auf der Spannung (VL minus Vbe) und über die Eingangsklemme A auf Null V gehalten. Die zweite pn-Grenzschichtdiode 12 liegt zwischen den Spannungen VH und und Null V. Wenn $V_{aus}$ ansteigt, bleibt die erste pn-Grenzschichtdiode 10 in Sperrichtung gepolt, da die Ausgangsklemme B kapazitiv so gekoppelt ist, daß sie ein höheres Potential als Eingangsklemme A annimmt; die zweite pn-Grenzschichtdiode 12 liegt zwischen den Spannungen VH und $V_{aus}$.

Fig. 5B zeigt schematisch den rein kapazitiven Effekt von T5 zwischen den Klemmen A und B. Hier ist zu beachten, daß Cfb und CLi als variable Kapazitäten dargestellt sind, da sie durch in Sperrichtung gepolte p-n-Grenzschichten (Sperrschichtkapazität) gebildet werden, die verschiedenen Sperrspannungsbedingungen unterworfen sind. Die dritte pn-Grenzschichtdiode 14 in Fig. 5A ist als feste Kapazität Cp dargestellt; sie hat tatsächlich keinen Einfluß auf die Arbeitsweise der Schaltung. In Fällen, bei denen wie in Fig. 3B Cp groß ist, muß beachtet werden, daß Cp die Wirkung der Bootstrap-Kapazität Cfb nicht beeinflußt.

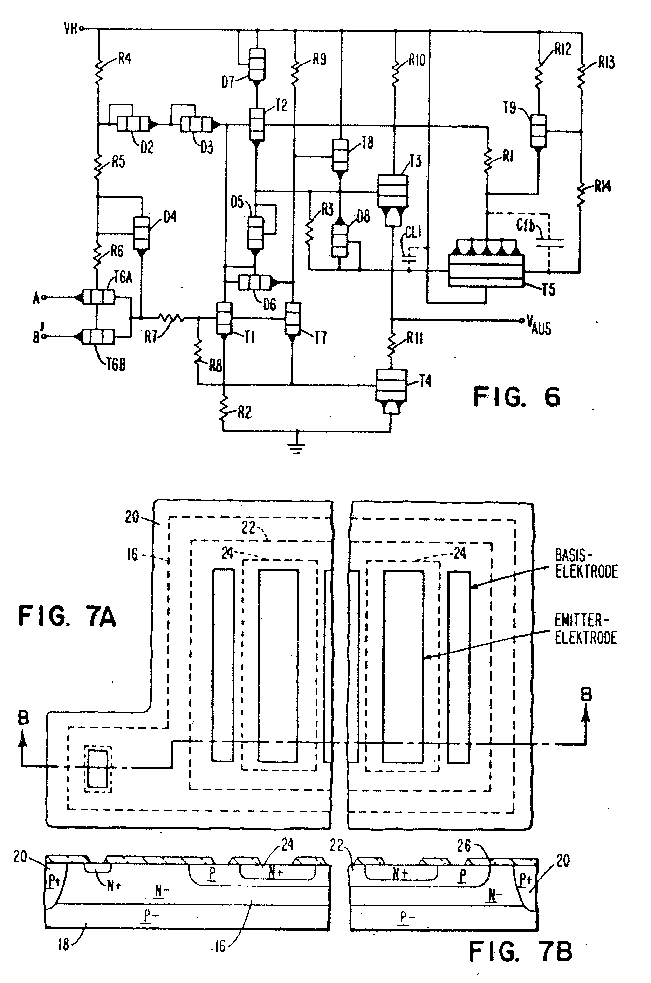

Fig. 6 zeigt eine zweite Ausführungsform der Erfindung in Form eines NAND—Treiberschaltkreises mit zwei Eingangssignalen. In Fig.

6 und Fig. 4 übereinstimmende Bezugzeichen betreffen Elemente mit ähnlichen Funktionen. Der Schaltkreis besteht aus einem UND—Glied mit zwei Eingängen A und B, die mit den Emittern der Transistoren T6A und T6B verbunden sind. Der als Diode geschaltete Transistor D4 zwischen der Basis und dem Kollektor von T6A und T6B verhindert, daß diese tief in das Sättigungsgebiet gelangen. Die Kollektoren von T6A und T6B sind über Widerstand R7 mit den Basen von T1 und T7 gekoppelt. Die Emitter von T1 und T7 sind mit der Basis des Transistors T4 verbunden, der zum Herabsetzen der Spannung auf Massepotential dient. Der Kollektor von T1 ist mit dem Eingang des Verstärkungstransistors T2 verbunden, sowie mit den Dioden D2 und D3, die über R4 mit VH gekoppelt sind, um eine tiefe Sättigung von T1 zu vermeiden. Der Emitter von T2 ist mit der Basis des Ausgangs-Treiber-Transistors T3 verbunden, dessen Emitter wiederum mit dem Ausgang $V_{aus}$ verbunden sind. Der Kollektor von T7 ist mit der Basis von T8 gekoppelt, dessen Emitter mit der Basis von T3 verbunden ist, um einen zusätzlichen Treiberstrom für T3 zu liefern. Der Strom zum Treiben von T2 wird durch die Kombination T9, R1, R12 und R13 geliefert, die zusammen funktionell mit D1 und R1 in Fig. 4 äquivalent sind. Das Element T5 liefert die spannungsabhängigen Kapazitäten Cfb und Cli, die mit dem Ausgang am Emitter von T3 gekoppelt sind. Damit sich die gewünschten Charakteristiken ergeben, ist T5 als bipolares Element mit fünf Emittern und mehrfachen Basiskontakten ausgebildet; diese Struktur wird später noch näher besprochen. Die als Diode geschalteten Transistoren D8, D5 und D6, tragen dazu bei, Strom über T1 und T7 an T4 zu liefern, wenn das Ausgangssignal vom Wert VH gegen Masse getrieben wird. Die diode D7 hindert T2 daran, tief in den Sättigungsbereich zu gelangen.

Ein Beispiel fur die Dimensionierung der in der Schaltung nach Fig. 6 verwendeten Widerstände ist im folgenden angegeben:

Widerstand R1 zwischen der Basis von T2 und den Emittern entsprechenden Bereichen von T5:
$$R1 = 2 \text{ k}\Omega \ \Omega$$

Widerstand R2 zwischen Emitter von T1 und Masse:
$$R2 = 0,4 \text{ k}\Omega$$

Widerstand R3 parallel zu D8:
$$R3 = 2 \text{ k}\Omega$$

Widerstand R4 zwischen VH und Kollektor von D2:
$$R4 = 5,8 \text{ k}\Omega$$

Widerstand R5 zwischen den Kollektoren von D2 und D4:
$$R = 0,2 \text{ k}\Omega$$

Widerstand R6 zwischen den Basisanschlüssen von T6A und D4:
$$R6 = 1 \text{ k}\Omega$$

Widerstand R7 zwischen den Kollektoren von T6A, T6B und der Basis von T1:
$$R7 = 0,5 \text{ k}\Omega$$

Widerstand R8 zwischen Basis und Emitter von T1:
$$R8 = 3 \text{ k}\Omega$$

Widerstand R9 zwischen VH und der Basis von T8:
$$R9 = \text{ k}\Omega$$

Widerstand R10 zwischen VH und dem Kollektor von T3:
$$R10 = 20 \ \Omega$$

Widerstand R11 zwischen dem Emitter von T3 und dem Kollektor von T4:
$$R11 = 20 \ \Omega$$

Widerstand R12 zwischen VH und dem Kollektor von T9:
$$R12 = 0,15 \text{ k}\Omega$$

Widerstand R13 zwischen VH und der Basis von T9:
$$R13 = 3 \text{ k}\Omega$$

Widerstand R14 zwischen der Basis von T9 und dem einem Kollektor entsprechenden Bereich von T5:
$$R14 = 7 \text{ k}\Omega.$$

Im Betrieb arbeitet der Schaltkreis von Fig. 6 in ähnlicher Weise wie der von Fig. 4, wenn das zusätzliche logische UND-Glied am Eingang berücksichtigt wird. Wenn eines oder beide der Eingangssignale A und/oder B' den niederen logischen Pegel aufweisen (Null V), so leitet entweder T6A oder T6B oder aber beide und führen dazu, daß die Basis von T1 und T7 ein Potential in der Nähe des Massepotentials (Null V) sehen. Da T1 und T7 nicht leiten, bleibt auch T4 nicht leitend. Das Ausgangssignal $V_{aus}$ hat zu diesem Zeitpunkt schon einen Wert von im wesentlichen VH erreicht und behält dieses Potential solange bei, bis beide Eingangssignale A und B' wieder den hohen logischen Pegel einnehmen. Wenn beide Eingangssignale A und B' ein ausreichend hohes Potential aufweisen, so daß die Transistoren T6A und T6B nicht mehr leiten, steigt das Potential an der Basis von T1 und T7 an, so daß diese leitend werden. Es fließt dann ein Strom durch T1 und T7, zur Basis T4, der dem Transistor T4 ansetzt und so $V_{aus}$ gegen das Massepotential zieht. Die Dioden D8, D5 und D6 liefern zusammen mit T1 und T7 zusätzlichen Strom an T4, und zwar in Abhängigkeit der Belastung der Ausgangsklemme. Die zwischen die Kollektoren von T1 und T7 geschaltete Diode D6 bewirkt einen Ausgleich der kollektorströme dieser beiden Transistoren.

Wenn das Ausgangssignal $V_{aus}$ auf Masse liegt, sind T2 und T3 nichtleitend. Der Widerstand-Spannungsteiler R13 und R14 liegt nun zwischen VH und Masse (über die Basis von T5) und das Potential an der Basis von T9 schaltet T9 ein und lädt die Mehrfachemitter von T5 auf ein Potential, das ungefähr ein Vbe-Spannungsabfall unter dem Potential liegt, das durch den Spannungsteiler R13 und R14 bestimmt ist. Die

Rückkoppelkapazität Cfb wird dadurch auf dasselbe Potential geladen. Gleichzeitig wird die interne Lastkapazität CLi auf VH geladen. Wenn eines oder beide der Eingangssignale A und/oder B genügend stark abfallen, um T6A oder T6B einzuschalten und somit T1, T7 und T4 in den Sperrzustand übergehen, steigt das Potential an der Basis von sowohl T2 und T8 gegen VH, T2 und T8 werden leitend, dadurch auch T3 und $V_{aus}$ kann ansteigen. Wie früher beschrieben, führt der Anstieg von $V_{aus}$ zu einer kapazitiven Kopplung der in Sperrichtung geschalteten Emitter von T5 und zu einem ausreichend hohen Potential, um Strom an T2 zu liefern, bis $V_{aus}$ auf den Wert VH ansteigt. Wenn das Potential an den Mehrfachemittern von T5 ansteigt, sperrt T9, da sein Emitter ein höheres Potential aufweist als seine Basis.

Die Fig. 7A und 7B zeigen die Struktur des Elements T5, wie es in den Schaltkreis von Fig. 6 eingebaut ist; für alle Transistoren wird dabei ein gemeinsamer Herstellprozeß verwendet. Das kapazitive Element wird in einer isolierten Diffusionswanne in form eines dem Kollektor entsprechend ein Bereichs 16 aus epitaktischem N—Silicium gebildet, das auf einem P—Substrat 18 erzeugt wurde; die Wanne ist durch die Isolationsbereiche 20 begrenzt. Die Diffusionswanne ist im wesentlichen identisch mit denjenigen, die für die anderen bipolaren Elemente auf dem Schaltkreisplättchen verwendet werden. Obwohl die übrigen Transistorstrukturen auf dem Substrat einen vergrabenen N+−Subkollektor verwenden, fehlt ein solcher in dem kapazitiven Element, um die Dichte der Isolationsfehler (sogenannte Pipe-Fehler) auf ein Minimum herabzusetzen und maximalen Kollektorwiderstand zu erreichen. Aus demselben Grund wird der Kontakt zum Kollektor in einer Erweiterung des dem Kollektor entsprechenden Bereichs 16 angebracht. Innerhalb des dem Kollektor entsprechenden Bereichs 16 ist ein einzelner der Basisentsprechender Bereich 22 mit einer Leitfähigkeit vom P—Typ eindiffundiert und innerhalb des der Basis entsprechenden Bereichs 22 eine Mehrzahl von dem Emitter entsprechenden Bereichen 24, beispielsweise 5. Eine geeignete Isolationsschicht 26 bedeckt die Oberfläche des Elements mit Ausnahme der Kontaktlöcher, an denen die über der Struktur liegenden nicht gezeichneten Leiterbahnen einen ohmschen Kontakt mit den verschiedenen Teilen des dargestellten Halbleitersubstrats bilden. Alle dem Emitter entsprechenden Bereiche sind mit einem gemeinsamen Leiter verbunden, der fingerähnliche Ausstrahlungen aufweist, die sich längs der dem Emitter entsprechenden Bereiche 24 erstrecken. In ähnlicher Weise sind Mehrfachkontakte, beispielsweise sechs, zur Kontaktierung des der Basis entsprechenden Bereichs 22 vorgesehen.

Die Kapazität des Rückkoppelkondensators Cfb kann variiert werden, indem Anzahl und Größe, (d.h. die Fläche der Grenzschicht) der Emitterbereiche vergrößert oder verkleinert werden. Der Wert von Cfb kann geändert werden, wobei sich die Kapazität der Basis-Kollektor-Grenzschicht nur wenig oder gar nicht ändert, so daß das Verhältnis von Cfb zu CLi ebenfalls eingestellt werden kann. Da der dem Kollektor entsprechende Bereich 16 direkt mit VH verbunden ist, sind die normalerweise großen Kapazitäten Kollektor-Isolation und Kollektor-Substrat von den aktiven Klemmen des Elements isoliert.

Die bisherige Beschreibung bezog sich auf NPN—Transistoren; für den Fachmann ist es jedoch ohne weiteres möglich, mit Hilfe de Bekannten Ersetzungsregeln anstelle der NPN-Transistoren solche vom Typ PNP zu verwenden. Das mit T5 bezeichnete kapazitive Element wurde in den Zeichnungen mit den Symbolen für einen Bipolartransistor dargestellt; dies geschah hauptsächlich, um die strukturellen Ähnlichkeiten des Elements mit konventionellen Bipolartransistoren zu unterstreichen. Es muß jedoch betont werden, daß Element 5 nicht in einem Bereich arbeitet, in dem eine Transistorwirkung auftritt.

**Patentansprüche**

1. Halbleitersperrschichtkapazität in integrierter Bauweise mit ersten pn-Grenzschichtdioden (10, Figur 5a) und mit zweiten (12) pn-Grenzschichtdioden, die bezüglich der ersten pn-Grenzschichtdioden umgekehrt gepolt sind und bei der all pn-Grenzschichtdioden in Sperrichtung betrieben werden, dadurch gekennzeichnet, daß jeweils erste (10), zweite (12) und in Richtung der ersten gepolte dritte pn-Grenzschichtdioden (14) in Reihe zwischen einem Bezugspotential (Masse, Figur 5A) und einer Ausgangsklemme (B) angeordnet und zwischen der ersten und der zweiten pn-Grenzschichtdiode eine Eingangsklemme (A) und zwischen der zweiten und der dritten pn-Grenzschichtdiode eine Vorspannungsklemme (VH) angeschlossen sind, so daß die Kapazität der zwischen Eingangsklemme (A in Fig. 5) und Ausgangsklemme (B in Fig. 5) liegenden ersten pn-Grenzschichtdiode durch die zweite pn-Grenzschichtdiode von dem an der dritten pn-Grenzschichtdiode liegenden Bezugspotential kapazitiv getrennt ist.

2. Halbleitersperrschichtkapazität nach Anspruch 1, dadurch gekennzeichnet, daß die pn-Grenzschichtdioden als eine einem Transistor entsprechende Struktur auf einem einzigen Halbleiterplättchen ausgebildet sind, wobei die erste pn-Grenzschichtdiode einen dem Emitter entsprechenden Bereich (24, Fig. 7) zusammen mit einem der Basis entsprechenden Bereich (22) umfaßt, die zweite pn-Grenzschichtdiode den der Basis entsprechenden Bereich (22) zusammen mit einem dem Kollektor entsprechenden Bereich (16) und die dritte pn-Grenzschichtdiode den dem Kollektor entsprechenden Bereich (16) zusammen mit einem Isolierbereich (18, 20).

3. Halbleitersperrschichtkapazität nach anspruch 2, dadurch gekennzeichnet, daß eine Mehrzahl der dem Emitter entsprechenden Bereiche (24, Fig. 7A) in einem gemeinsamen der Basis entsprechenden Bereich (22) angeordnet und mit einer gemeinsamen Ausgangsklemme verbunden sind.

4. Halbleitersperrschichtkapazität nach Anspruch 2 oder 3, dadurch gekennzeichnet, daß an der Vorspannungsklemme ein konstantes Vorspannungspotential (VH) anliegt.

5. Bootstrap-Schaltung mit einer Halbleiterschichtkapazität nach einem der Ansprüche 1 bis 4, dadurch gekennzeichnet, daß die Halbleitersperrschichtkapazität (T5, Fig. 4) als Rückkoppelvorrichtung in einer integrierten bipolaren Bootstrap-Schaltung angeordnet ist, daß das Ausgangssignal mindestens einer Verstärkerstufe (T2, T3) mit der Eingangsklemme (A) der Halbleitersperrschichtkapazität verbunden ist, und daß die Ausgangsklemme (B) der Halbleitersperrschichtkapazität das Rückkoppelsignal führt.

6. Bootstrap-Schaltung nach Anspruch 5, dadurch gekennzeichnet, daß die Verstärkerstufe einen Emitterfolger (T2, T3) vom Darlington-Typ umfaßt.

7. Bootstrap-Schaltung nach Anspruch 6, dadurch gekennzeichnet, daß die Vorspannungsklemme (VH, Fig. 5A) der Halbleitersperrschichtkapazität (T5) mit der Stromquelle für die Verstärkerstufe verbunden ist.

8. Bootstrap-Schaltung nach einem der Ansprüche 5 bis 7, dadurch gekennzeichnet, daß zwischen die Versorgungsspannung und die Eingangsklemme (A) der Halbleitersperrschichtkapazität (T5) ein Spannungsteiler (R13, R14) geschaltet ist, dessen Mittelabgriff mit der Basis eines Transistors (T9) verbunden ist, der mit seinem Kollektor über einen Widerstand (R12) an die Versorgungsspannung und mit seinem Emitter an die Ausgangsklemme der Halbleitersperrschichtkapazität (T5), sowie über einen Widerstand (R1) an die Basis des ersten Transistors (T2) des Emitterfolgers angeschlossen ist.

9. Bootstrap-Schaltung nach Anspruch 8, dadurch gekennzeichnet, daß die Basis und der Emitter eines Eingangstransistors (T1) mit der Basis bzw. dem Emitter eines zweiten Transistors (T7) verbunden sind, daß der Kollektor des zweiten Transistors (T7) mit der Basis eines dritten Transistors (T8) und über einen Widerstand (R9) mit der Versorgungsspannung verbunden ist und daß der Kollektor des dritten Transistors (T8) an die Versorgungsspannung und sein Emitter an die Basis des zweiten Transistors (T3) des Emitterfolgers angeschlossen ist.

10. Bootstrap-Schaltung nach Anspruch 9, dadurch gekennzeichnet, daß der Kollektor des Eingangstransistors (T1) mit dem Kollektor eines als Diode geschalteten vierten Transistors (D6) verbunden ist, dessen Emitter an den Kollektor des zweiten Transistors (T7) angeschlossen ist, daß die Basis des vierten Transistors (D6) mit dem Emitter eines als Diode geschalteten fünften Transistors (D5) verbunden ist, dessen Kollektor an die Basis des zweiten Transistors (T3) des Emitterfolgers angeschlossen ist und daß parallel zur Basis und Emitter des zweiten Transistors (T3) des Emitterfolgers eine Diode (D8) geschaltet ist.

**Claims**

1. Integrated semiconductor barrier layer capacitance having a first p-n junction diode (10, Fig. 5a) and a second p-n junction diode (12) which is oppositely poled with respect to the first p-n junction diode, and in which all the p-n junction diodes are operated in the backward direction, characterized in that the first diode (10), the second diode (12) and a third p-n junction diode (14) are arranged in series between a reference potential (ground, Fig. 5A) and an output terminal (B), the third diode (14) being poled in the same direction as the first diode (10), and that an input terminal (A) is connected between the first and the second p-n junction diodes, and that a bias potential (VH) is connected to a terminal between the second and the third p-n junction diodes so that the capacitance of the first p-n junction diode provided between the input terminal (A in Fig. 5) and the output terminal (B in Fig. 5) is separated by the capacitance of the second p-n junction diode from the reference potential connected to the third p-n junction diode.

2. Semiconductor barrier layer capacitance as claimed in claim 1, characterized in that the p-n junction diodes are provided by a single transistor structure having an emitter, a base and a collector formed in a semiconductor chip, the first p-n junction diode comprising a region (24, Fig. 7) corresponding to the emitter of the transistor and a region (22) corresponding to the base of the transistor, the second p-n junction diode comprising the region (22) corresponding to the base and a region (16) corresponding to the collector, and the third p-n junction diode comprising the region (16) corresponding to the collector and an isolation region (18, 20) isolating the transistor structure in the semiconductor chip.

3. Semiconductor barrier layer capacitance as claimed in claim 2, characterized in that a plurality of the regions (24, Fig. 7A) each corresponding to the emitter are arranged in a common region (22) corresponding to the base, and are connected to a common output terminal.

4. Semiconductor barrier layer capacitance as claimed in claim 2 or 3, characterized in that a constant biasing potential (VH) is applied at the bias potential terminal.

5. Bootstrap circuit comprising a semiconductor barrier layer capacitance as claimed in any one of claims 1 to 4, characterized in that the semiconductor barrier layer capacitance (T5, Fig. 4) is arranged as a feedback device in an integrated bipolar bootstrap circuit, that the output signal of at least one amplifier stage (T2, T3) is connected to the input terminal (A) of the semiconductor barrier layer capacitance, and that the output terminal (B) of the semiconductor barrier layer capacitance transfers the feedback signal.

6. Bootstrap circuit as claimed in claim 5, characterized in that the amplifier stage comprises an emitter follower (T2, T3) of the Darlington type.

7. Bootstrap circuit as claimed in claim 6, characterized in that the bias potential terminal (VH, Fig. 5A) of the semiconductor barrier layer capacitance (T5) is connected to a current source for the amplifier stage.

8. Bootstrap circuit as claimed in one of claims 5 to 7, characterized in that between the supply voltage and the input terminal (A) of the semiconductor barrier layer capacitance (T5) a voltage divider (R13, R14) is arranged having its centre tap connected to the base of a transistor (T9) which with its collector is connected via a resistor (R12) to the supply voltage, and with its emitter to the output terminal of the semiconductor barrier layer (T5), as well as via a resistor (R1) to the base of the first transistor (T2) of the emitter follower.

9. Bootstrap circuit as claimed in claim 8, characterized in that the base and the emitter of an input transistor (T1) are respectively connected to the base and the emitter, of a second transistor (T7), that the collector of the second transistor (T7) is connected to the base of a third transistor (T8) and via a resistor (R9) to the supply voltage, and that the collector of the third transistor (T8) is connected to the supply voltage and its emitter to the base of the second transistor (T3) of the emitter follower.

10. Bootstrap circuit as claimed in claim 9, characterized in that the collector of the input transistor (T1) is connected to the collector of a fourth transistor (D6) which is connected as a diode and has its emitter connected to the collector of the second transistor (D7), that the base of the fourth transistor (D6) is connected to the emitter of a fifth transistor (D5) which is connected as a diode and has its collector connected to the base of the second transistor (T3) of the emitter follower, and that a diode (D8) is connected across the base and emitter of the second transistor (T3) of the emitter follower.

## Revendications

1. Capacité de la zone d'épuisement réalisée dans la technique des semi-conducteurs intégrés ayant des premières diodes à jonction p-n (10, figures 5A), et des secondes diodes à jonction p-n (12) qui, par rapport aux premières diodes à jonction p-n, sont inversement polarisées, dans laquelle toutes les diodes travaillent dans le sens bloqué, caractérisée en ce que respectivement des troisièmes diodes à jonction p-n (14), montées en série avec les premières et secondes diodes, et polarisées dans le même sens que les premières diodes, sont connectées entre un potentiel de référence (terre, figure 5A) et une borne de sortie (B), et en ce qu'entre les premières et secondes diodes est connectée une borne d'entrée (A) et entre les secondes et troisièmes diodes à jonction p-n est connectée une borne de tension de polarisation (VH) de sorte que la capacité des premières diodes situées entre la borne d'entrée (A) et la borne de sortie (B) est séparée capacitivement par les secondes diodes du potentiel de référence appliqué sur les troisièmes diodes.

2. Capacité selon la revendication 1, caractérisée en ce que les diodes à jonction p-n forment entre-elles une structure correspondant à un transistor sur une seule microplaquette semi-conductrice, la première diode comportant une région (24, figure 7) qui correspond à l'émetteur avec une région (22) qui correspond à la base, la seconde diode comportant la région (22) qui correspond à la base avec une région (16) qui correspond au collecteur, et la troisième diode comportant la région (16) qui correspond au collecteur avec une région d'isolement (18, 20).

3. Capacité selon la revendication 2, caractérisée en ce qu'une pluralité de régions (24, figure 7A) correspondant à l'émetteur sont disposées dans une région commune (22) correspondant à la base du transistor et connectées à une borne de sortie commune.

4. Capacité selon l'une quelconque des revendications 2 ou 3, caractérisée en ce qu'un potentiel de polarisation constant (VH) est appliqué à la borne de tension de polarisation.

5. Circuit à contre-réaction comportant une capacité semi-conductrice de la zone d'épuisement selon l'une quelconque des revendications 1 à 4, caractérisé en ce que la capacité semi-conductrice de la zone d'épuisement (T5, figure 4) forme un dispositif à contre-réaction dans un circuit bipolaire intégré du type à contre-réaction, en ce que le signal de sortie d'au moins un étage d'amplification (T2, T3) est connecté à la borne d'entrée (A) de la capacité semi-conductrice de la zone d'épuisement, et en ce que la borne de sortie (B) de la capacité semi-conductrice de la zone d'épuisement transfère le signal de contre-réaction.

6. Circuit selon la revendication 5, caractérisé en ce que l'étage d'amplification comporte un émetteur-suiveur (T2, T3) du type Darlington.

7. Circuit selon la revendication 6, caractérisé en ce que la borne de tension depolarisation (VH, Figure 5A) de la capacité semi-conductrice de la zone d'épuisement est connectée à la source de courant pour l'étage d'amplification.

8. Circuit selon l'une quelconque des revendications 5 à 7, caractérisé en ce que l'on dispose entre la tension d'alimentation et la borne d'entrée (A) de la capacité semi-conductrice de la zone d'épuisement (T5) un diviseur de tension (R13, R14) dont la prise centrale est connectée à la base d'un transistor (T9) qui, avec son collecteur, est connecté à travers une résistance (R12) à la tension d'alimentation, et avec son émetteur à la borne de sortie de la capacité semi-conductrice de la zone d'épuisement (T5) ainsi qu'à travers une résistance (R1) à la base d'un premier transistor (T2) de l'émetteur-suiveur.

9. Circuit selon la revendication 8, caractérisé en ce que la base et l'émetteur d'un transistor d'entrée (T1) sont connectés à la base et l'émetteur respectivement d'un second transistor (T7), en ce que le collecteur du second transistor (T7) est connecté à la base d'un troisième transistor (T8) et, à travers une résistance (R9), à la tension d'alimentation, et en ce que le collecteur d'un troisième transistor (T8) est connecté à la tension d'alimentation et son émetteur à la base du second transistor (T3) de l'émetteur-suiveur.

10. Circuit selon la revendication 9, caractérisé en ce que le collecteur du transistor d'entrée (T1) est connecté au collecteur du quatrième transistor (D6) qui forme une diode dont l'émetteur est connecté au collecteur du second transistor (T7), en ce que la base du quatrième transistor (D6) est connectée à l'émetteur d'un cinquième transistor (D5) qui forme une diode dont le collecteur est connecté à la base du second transistor (T3) de l'émetteur-suiveur, et en ce qu'une diode (D8) est montée en parallèle sur la jonction base-émetteur du second transistor (T3) de l'émetteur-suiveur.

0 000 169

FIG. 1

FIG. 2

FIG. 3A

FIG. 3B

FIG. 4

FIG. 5A

FIG. 5B

1

FIG. 6

FIG. 7A

BASIS-
ELEKTRODE

EMITTER-
ELEKTRODE

FIG. 7B